# EUROPEAN PATENT APPLICATION

(11) **EP 4 550 984 A1**
(43) Date of publication of application: **07.05.2025**
(21) Application number: 24210205.1
(22) Date of filing: 31.10.2024
(51) Int. Cl.: H10F 39/12

(54) **X-RAY DETECTOR**

(30) Priority: 01.11.2023 US 202363595077 P
(71) Applicant: Rayence Co., Ltd., Hwaseong-si, Gyeonggi-do 18449 (KR); Vatech Ewoo Holdings Co., Ltd., Hwaseong-si, Gyeonggi-do, 18449 (KR); Qpix solutions Inc., Morrisville, NC 27560 (US)
(72) Inventor: YUN, Seungman, Morrisville, 27560 (US); LEE, Wonjun, Morrisville, 27560 (US); LEE, Seunghyeon, Morrisville, 27560 (US); Hany, Ibrahim, Morrisville, 27560 (US); Williamson, Carter, Morrisville, 27560 (US)
(74) Representative: Lorenz & Kollegen

(57) **Abstract**

Proposed is an X-ray detector including first and second electrodes on a substrate, and a photoconductor layer provided between the first electrode and the second electrode and configured to contain perovskite, wherein the photoconductor layer may include a first photoconductive layer made of a first perovskite with a columnar crystal structure, and a second photoconductive layer provided on the first photoconductive layer, and made of a second perovskite with a cubic crystal structure.

## Description

### CROSS REFERENCE TO RELATED APPLICATION

The present application claims priority to US Patent Application No. 63/595,077, filed November 1, 2023, the entire contents of which is incorporated herein for all purposes by this reference.

### BACKGROUND

### Technical Field

The present disclosure relates to an X-ray detector.

### Description of the Related Art

In recent years, digital detectors have become widely used for X-ray imaging.

X-ray detectors are divided into indirect-conversion and direct-conversion types. Indirect-conversion detectors have a scintillator that first converts X-rays into visible light, and then the visible light is converted to electrical signals. In direct conversion, on the other hand, a photoconductor that absorbs X-rays and directly creates electrical signals is used.

As a photoconductor, perovskite has attracted substantial attention. However, according to current research, there are limitations in applying perovskite as a photoconductor for X-ray detectors.

### SUMMARY

Accordingly, the present disclosure has been made keeping in mind the above problems occurring in the related art, and the present disclosure is intended to provide a method for effectively using perovskite as a photoconductor for X-ray detectors.

In order to achieve the above objective, according to an aspect of the present disclosure, there is provided an X-ray detector including: first and second electrodes on a substrate; and a photoconductor layer provided between the first electrode and the second electrode and configured to contain perovskite, wherein the photoconductor layer may include: a first photoconductive layer made of a first perovskite with a first crystal size; and a second photoconductive layer provided on the first photoconductive layer, and made of a second perovskite with a second crystal size larger than the first crystal size.

The crystal size of the first perovskite may be 1 to 3 µm.

The crystal size of the second perovskite may be 3 to 10 µm.

The first photoconductive layer may have a columnar crystal structure, and the second photoconductive layer may have a cubic crystal structure.

Within the second photoconductive layer, the crystal size of the second perovskite may gradually increase as a distance from the substrate increases.

The thickness of the second photoconductive layer may be greater than the thickness of the first photoconductive layer.

The thickness of the first photoconductive layer may be 1 to 50 µm, and the thickness of the second photoconductive layer may be 60 to 500 µm.

The perovskites may be CsPbBr3, Cs2AgBiBr6, MAPbI3, or MAPbBr3.

According to the present disclosure, in forming a photoconductor layer using perovskite, the lower first photoconductive layer is made of perovskite crystals with a fine columnar structure, whereas the upper second photoconductive layer is made of perovskite crystals with a cubic structure whose crystal size gradually increases toward the top.

Therefore, the photoconductor layer made of perovskite can have excellent electrical properties while ensuring sufficient adhesion to a substrate.

### BRIEF DESCRIPTION OF THE DRAWINGS

The above and other objectives, features, and other advantages of the present disclosure will be more clearly understood from the following detailed description when taken in conjunction with the accompanying drawings, in which:
FIG. 1 is a schematic view of an X-ray detector according to an embodiment of the present disclosure;
FIG. 2 is a cross-sectional view schematically showing an X-ray detector according to an embodiment of the present disclosure; and
FIG. 3 is an enlarged cross-sectional view of a photoconductor layer according to an embodiment of the present disclosure.

### DETAILED DESCRIPTION

Hereinafter, embodiments of the present disclosure will be described in detail with reference to the drawings.

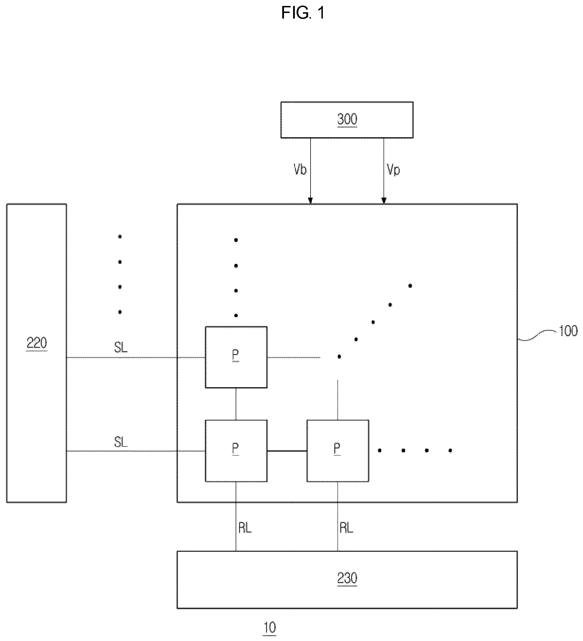

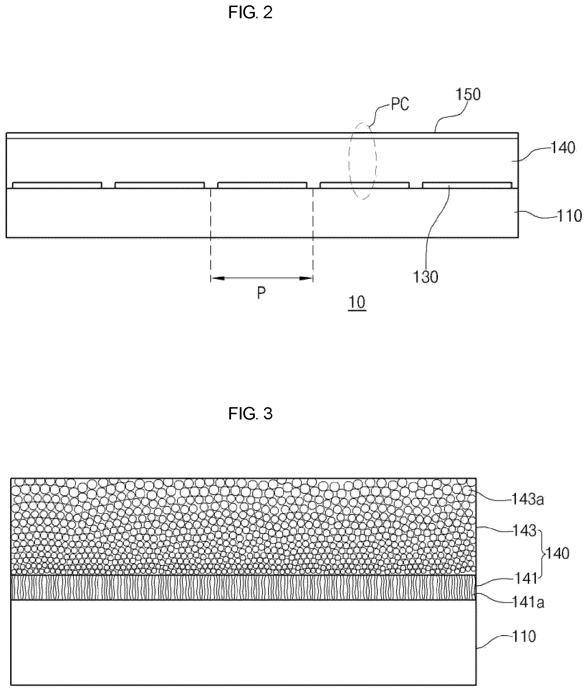

FIG. 1 is a schematic view of an X-ray detector according to an embodiment of the present disclosure. FIG. 2 is a cross-sectional view schematically showing an X-ray detector according to an embodiment of the present disclosure. FIG. 3 is an enlarged cross-sectional view of a photoconductor layer according to an embodiment of the present disclosure.

In FIG. 3, for convenience of explanation, first and second electrodes located below and above a photoconductor layer are omitted.

Referring to FIGS. 1 to 3, an X-ray detector 10 according to an embodiment of the present disclosure corresponds to a direct-conversion X-ray detector provided with a photoconductor layer 140.

The X-ray detector 10 may include a sensor panel 100, a driving circuit part for driving the sensor panel 100, and a power circuit 300 that supplies a driving voltage (or power voltage) to drive the X-ray detector 10.

The sensor panel 100 may be a direct-conversion sensor panel 100 that directly converts incident X-rays into electrical signals.

Although not specifically shown, the sensor panel 100 may include: an active area, which is the area that actually receives and detects X-rays; and a non-active area located outside the active area.

In the active area, a pixel array composed of a plurality of pixels P is disposed on a substrate 110, and the pixels P may be arranged in a matrix form along a plurality of row lines and a plurality of column lines.

On the substrate 110, a plurality of scan lines (or gate lines) SL extending along the row lines and a plurality of signal transmission lines (or data lines) RL extending along the column lines may be disposed. The scan lines SL and the signal transmission lines RL may be connected to corresponding pixels P.

Meanwhile, in the embodiment, the substrate 110 may be composed of, but is not limited to, a CMOS substrate, a glass substrate, or a plastic substrate having flexible properties.

The driving circuit part for driving the sensor panel 100 may include a scan circuit 220 and a readout circuit 230.

In this case, the scan circuit 220 sequentially scans the scan lines SL and applies a scan signal of a turn-on level. Accordingly, individual row line is sequentially selected, and data, which is an electrical signal stored in the pixel P located in the selected row line, may be output to the corresponding signal transmission line RL. Then, the readout circuit 230 may receive the data stored in the pixel P through the signal transmission line RL.

Each pixel P of the sensor panel 100 may be provided with a photoconductive element PC that detects X-rays and generates a corresponding electrical signal.

In this regard, the photoconductive element PC may include: a first electrode (or pixel electrode) 130, which is a lower electrode provided on the substrate 110; a second electrode (or common electrode) 150, which is an upper electrode located above the first electrode 130; and the photoconductor layer 140 interposed between the first electrode 130 and the second electrode 150.

The first electrode 130 may be provided in a patterned form on a pixel basis corresponding to each pixel P.

The photoconductor layer 140 provided on the first electrode 130 may be formed, for example, continuously along the pixels P substantially arranged in the active area. In other words, the photoconductor layer 140 may be formed corresponding to the pixels P arranged in the active area.

As a photoconductor forming the photoconductor layer 140, perovskite may be used.

The perovskite is a material with a crystal structure following the formula ABX3, where A denotes a monovalent cation, B denotes a metal cation, and X may denote a halogen anion.

The perovskite may be, but is not limited to, CsPbBr3, Cs2AgBiBr6, MAPbI3, or MAPbBr3.

Meanwhile, the photoconductor layer 140 of perovskite may be formed, for example, by a solution method, which will be explained in more detail below.

The second electrode 150 provided on the photoconductor layer 140 may be formed, for example, continuously along the pixels P substantially arranged in the active area. In other words, the second electrode 150 may be formed corresponding to the pixels P arranged in the active area. A bias voltage Vb (i.e., reverse voltage) may be applied to the second electrode 150.

In order to implement charge generation due to photoelectric action in the photoconductive element PC configured as above, a pixel voltage Vp, which is a driving voltage (or first driving voltage), may be applied to the first electrode 130, and a bias voltage Vb, which is a driving voltage (or second driving voltage), may be applied to the second electrode 150. Accordingly, a difference voltage between the bias voltage Vb and the pixel voltage Vp is applied to the photoconductive element PC, and in this state, when X-rays are incident, corresponding charges are generated by photoelectric action, and the generated charges may be collected at the first electrode 130.

The driving voltage may be generated and provided by the power circuit 300. In this regard, the power circuit 300 may generate the pixel voltage Vp and the bias voltage Vb and output the pixel voltage Vp and the bias voltage Vb to the sensor panel 100.

Meanwhile, in the embodiment, the photoconductor layer 140 of perovskite may be composed of, for example, a two-layer structure. In other words, the photoconductor layer 140 may include a first photoconductive layer 141, which is the lower layer, and a second photoconductive layer 143 which is the upper layer.

At this time, the first photoconductive layer 141 and the second photoconductive layer 143 may have different perovskite crystal structures.

Regarding this, for example, a crystal (or first crystal) 141a of perovskite (or first perovskite) forming the first photoconductive layer 141 is a fine crystal and may have a columnar structure, whereas a crystal (or second crystal) 143a of perovskite (or second perovskite) forming the second photoconductive layer 143 may have a cubic structure. As such, since each of the first photoconductive layer 141 and the second photoconductive layer 143 is formed with a perovskite crystal structure, the photoconductor layer 140 may have excellent electrical properties.

Regarding the structure of the first perovskite crystal 141a forming the first photoconductive layer 141, the size (or diameter) of the first perovskite crystal 141a is preferably approximately 1 to 3 µm, for example.

Due to its nature, perovskite has a large difference in thermal expansion coefficient from the substrate 110, and thus the photoconductor layer 140 may be detached (or peeled) from the substrate 110 depending on the temperature.

However, by forming the first photoconductive layer 141, which is the lower layer of the photoconductor layer 140, with crystals 141a having a columnar structure of a fine size of 1 to 3 µm, the adhesion characteristics of the photoconductor layer 140 are improved, so that the adhesion of the photoconductor layer 140 to the substrate 110 may be effectively ensured.

Regarding the formation of the first photoconductive layer 141, by repeating, for example, the process of applying and curing a mixture of a perovskite precursor (e.g., CsBr, PbBr2, etc.) and a solvent (e.g., a polar solvent) onto a substrate, the first photoconductive layer 141 may be formed as the fine crystals 141a with a columnar structure are grown.

Meanwhile, the thickness of the first photoconductive layer 141 may be appropriately set in consideration of an X-ray machine (or purpose) to which the X-ray detector 10 is applied. For example, the thickness of the first photoconductive layer 141 may be approximately 1 to 50 µm, preferably approximately 1 to 20 µm, but is not limited thereto.

Regarding the structure of the second perovskite crystal 143a forming the second photoconductive layer 143, the size (or diameter) of the second perovskite crystal 143a is preferably approximately 3 to 10 µm, for example.

As the size of the second perovskite crystal 143a increases, the porosity increases and the adhesion to the substrate 110 may be reduced. In addition, as previously mentioned, perovskite has a large difference in thermal expansion coefficient from the substrate 110, and thus the photoconductor layer 140 may be detached (or peeled) from the substrate 110 depending on the temperature. Considering this, it is desirable that the size of the second perovskite crystal 143a be 10 µm or less.

When the size of the second perovskite crystal 143a is smaller than 3 µm, it becomes difficult to maintain the cubic structure. Considering this, it is preferable that the size of the second perovskite crystal 143a be 3 µm or larger.

Thus, considering the porosity and cubic crystal structure within the photoconductor layer 140, the size of the second perovskite crystal 143a may be set to approximately 3 to 10 µm.

In addition, to realize the second perovskite crystal 143a of the above size, the size of the perovskite powder mixed in the solvent before application may be approximately 3 to 7 µm.

Meanwhile, as shown in FIG. 3, within the second photoconductive layer 143, the second perovskite crystal 143a may be configured to gradually increase in size going upward (i.e., away from the substrate 110).

That is, the second perovskite crystal 143a formed at the lower part of the second photoconductive layer 143 close to the substrate 110 may be relatively small in size, whereas the second perovskite crystal 143a formed at the upper part of the second photoconductive layer 143 away from the substrate 110 may be relatively large in size.

As such, in the part of the second photoconductive layer 143 close to the substrate 110, the small-sized perovskite crystal 143a with relatively high adhesion characteristics are formed, so that the adhesion of the photoconductor layer 140 to the substrate 110 may be effectively ensured.

Regarding implementing a structure in which the size of the crystal 143a gradually increases toward the top in the photoconductor layer 140 as described above: in the process of curing after applying the mixed solution of perovskite powder and solvent, heat is applied to the substrate 110 (more specifically, heat is applied from the bottom of the substrate 110) to first evaporate the solvent close to the substrate 110, which allows the size of the second perovskite crystal 143a to gradually increase toward the top.

Regarding curing conditions for the above curing process, the curing process may be performed on the applied perovskite solution at a temperature of approximately room temperature to 90 degrees for approximately 10 to 20 hours, for example.

Meanwhile, the thickness of the second photoconductive layer 143 containing the second perovskite crystal 143a may be appropriately set in consideration of an X-ray machine (or purpose) to which the X-ray detector 10 is applied.

In this regard, the second photoconductive layer 143 may be formed thicker than the first photoconductive layer 141, and the thickness of the second photoconductive layer 143 may be approximately 60 to 500 µm, but is not limited thereto.

As described above, in the embodiment of the present disclosure, in forming the photoconductor layer 140 using perovskite, the lower first photoconductive layer 141 is made of perovskite crystals with a fine columnar structure, whereas the upper second photoconductive layer 143 is made of perovskite crystals with a cubic structure whose crystal size gradually increases toward the top.

Therefore, the photoconductor layer 140 made of perovskite may have excellent electrical properties while ensuring sufficient adhesion to the substrate 110.

The above-described embodiment of the present disclosure is an example of the present disclosure, and free modification is possible within the scope included in the spirit of the present disclosure. Accordingly, the present disclosure includes modifications of the present disclosure within the scope of the appended claims and the equivalents thereof.

## Claims

1. An X-ray detector comprising:
first and second electrodes on a substrate; and
a photoconductor layer provided between the first electrode and the second electrode and configured to contain perovskite,
wherein the photoconductor layer comprises:
a first photoconductive layer made of a first perovskite with a first crystal size; and
a second photoconductive layer provided on the first photoconductive layer, and made of a second perovskite with a second crystal size larger than the first crystal size.

2. The X-ray detector of claim 1, wherein the crystal size of the first perovskite is 1 to 3 µm.

3. The X-ray detector of claim 1, wherein the crystal size of the second perovskite is 3 to 10 µm.

4. The X-ray detector of claim 1, wherein the first photoconductive layer has a columnar crystal structure, and the second photoconductive layer has a cubic crystal structure.

5. The X-ray detector of claim 3, wherein within the second photoconductive layer, the crystal size of the second perovskite gradually increases as a distance from the substrate increases.

6. The X-ray detector of claim 1, wherein a thickness of the second photoconductive layer is greater than a thickness of the first photoconductive layer.

7. The X-ray detector of claim 6, wherein the thickness of the first photoconductive layer is 1 to 50 µm, and the thickness of the second photoconductive layer is 60 to 500 µm.

8. The X-ray detector of claim 1, wherein the perovskites are CsPbBr3, Cs2AgBiBr6, MAPbI3, or MAPbBr3.
